# EUROPEAN PATENT APPLICATION

(11) **EP 4 570 968 A1**
(43) Date of publication of application: **18.06.2025**
(21) Application number: 23851575.3
(22) Date of filing: 21.07.2023
(51) Int. Cl.: C30B 15/20, C30B 29/06

(54) **SINGLE CRYSTAL FURNACE, HEAT CONDUCTION TOOL, AND CRYSTAL PULLING CONTROL METHOD FOR SINGLE CRYSTAL FURNACE**

(30) Priority: 09.08.2022 CN 202210952519; 07.04.2023 CN 202320765337 U
(71) Applicant: Longi Green Energy Technology Co., Ltd., Xi'an, Shaanxi 710100 (CN)
(72) Inventor: ZHU, Yonggang, Xi' an, Shaanxi 710100 (CN); LI, Qiao, Xi' an, Shaanxi 710100 (CN); DONG, Sheng, Xi' an, Shaanxi 710100 (CN); CAO, Jie, Xi' an, Shaanxi 710100 (CN); ZHANG, Weijian, Xi' an, Shaanxi 710100 (CN); BAI, Feng, Xi' an, Shaanxi 710100 (CN)
(74) Representative: Pfenning, Meinig & Partner mbB
(86) International application number: PCT/CN2023/108687
(87) International publication number: WO 2024/032353

(57) **Abstract**

Embodiments of this application provide a single crystal furnace, a heat conduction tool, and a crystal pulling temperature control method for the single crystal furnace. The single crystal furnace includes a furnace body and a heat transfer assembly. The furnace body is configured to grow a monocrystalline silicon rod. In an axial direction of the furnace body, the heat transfer assembly is arranged in the furnace body. The heat transfer assembly includes a heat transfer member. The heat transfer member is configured to contact with the monocrystalline silicon rod and conduct heat from the monocrystalline silicon rod. According to the single crystal furnace of the embodiments, the temperature of the monocrystalline silicon rod can be rapidly lowered, so that the crystal pulling speed can be further increased. In addition, the risk of collision around the monocrystalline silicon rod can be avoided. Therefore, the single crystal furnace can achieve both a high crystal pulling speed and high crystal pulling quality.

## Description

This application claims priorities to Chinese Patent Application No. 202210952519.4, field with the China National Intellectual Administration Property on August 9, 2022 and entitled "SINGLE CRYSTAL FURNACE AND CRYSTAL PULLING TEMPERATURE CONTROL METHOD THEREOF", and Chinese Patent Application No. 202320765337.6, filed with the China National Intellectual Administration Property on April 7, 2023 and entitled "HEAT CONDUCTION TOOL AND SINGLE CRYSTAL FURNACE", which are incorporated herein by reference in their entities.

### TECHNICAL FIELD

This application relates to the field of monocrystalline silicon pulling technologies, and in particular, to a single crystal furnace, a heat conduction tool, and a crystal pulling control method for the single crystal furnace.

### BACKGROUND

In the photovoltaic industry, most solar cells are manufactured using crystalline silicon as the raw material. Particularly, solar cells using monocrystalline silicon have a large market share among solar cells using crystalline silicon due to high conversion efficiency of monocrystalline silicon. As the demand for photovoltaic products increases, the demand for monocrystalline silicon in the photovoltaic market continues to increase. Monocrystalline silicon manufacturers are paying more and more attention to increasing the production capacity of monocrystalline silicon to meet market needs.

One way to increase the production capacity of monocrystalline silicon rods is to increase the crystal pulling speed to improve the production efficiency. At present, a mainstream approach of increasing the crystal pulling speed is to use a seed crystal to grow a monocrystalline silicon rod from a crucible silicon melt in a single crystal furnace. During the growth of the monocrystalline silicon rod, it is necessary to use a heat transfer structure arranged in the single crystal furnace to cool the monocrystalline silicon rod to increase the longitudinal temperature gradient for the growth of monocrystalline silicon rod, thereby increasing the crystal pulling speed. Such a non-contact radiation heat transfer structure can form a temperature gradient at the solid-liquid interface, reduce the temperature of the monocrystalline silicon rod, and increase the crystal pulling speed to a maximum of 1.9 mm/min. In order to further increase the crystal pulling speed, attempts have been made to change the heat transfer structure to make it as close to the monocrystalline silicon rod as possible.

However, the increase in the crystal pulling speed achieved by changing the heat transfer structure is limited, and the changed heat transfer structure is likely to collide with the monocrystalline silicon rod, leading to wire breakage or even falling of the rod, and resulting in crystal pulling defects or even accidents. Therefore, it is necessary to develop a single crystal furnace that can achieve a higher crystal pulling speed and ensure the crystal pulling quality.

### SUMMARY

This application provides a single crystal furnace, a heat conduction tool, and a crystal pulling temperature control method for the single crystal furnace, to solve the problem that contactless radiation heat exchange structures in existing single crystal furnaces cannot achieve both a high crystal pulling speed and high crystal pulling quality.

An embodiment of this application provides a single crystal furnace, including a furnace body and heat transfer assembly, where the furnace body is configured to grow a monocrystalline silicon rod;
in an axial direction of the furnace body, the heat transfer assembly is arranged in the furnace body; and
the heat transfer assembly is configured to contact with the monocrystalline silicon rod and conduct heat of the monocrystalline silicon rod.

Optionally, the heat transfer assembly includes a heat transfer member, and the heat transfer member includes a cylinder arranged in the furnace body; and
the cylinder is configured to contact with the monocrystalline silicon rod and conduct the heat of the monocrystalline silicon rod.

Optionally, the heat transfer assembly further includes a heat conduction tool, and the heat conduction tool is arranged on the heat transfer member and/or on an inner surface of the furnace body.

Optionally, a material of the heat conduction tool includes any one of a carbon-carbon material, a graphite material, and silicone grease.

Optionally, an inner diameter of the cylinder is smaller than a diameter of the monocrystalline silicon rod;
the heat transfer member further includes a flange arranged on an outer surface of the cylinder, the flange radially extends in a direction away from an axis of the cylinder, and the flange is configured to abut against and fit with the furnace body; and
a head of the monocrystalline silicon rod is in contact with an end portion of the cylinder to push the flange to separate from the furnace body.

Optionally, the heat conduction tool is fixed to an outer surface of the heat transfer member, and/or the heat conduction tool is fixed to the inner surface of the furnace body.

Optionally, the heat transfer member further includes a pressing plate; and
the heat conduction tool is arranged on a surface of the flange facing away from the monocrystalline silicon rod along a circumferential direction of the flange, and the pressing plate is stacked on the flange to retain and fix the heat conduction tool.

Optionally, an inner diameter of the cylinder is larger than a diameter of the monocrystalline silicon rod; and
the monocrystalline silicon rod passes through the cylinder, and the cylinder conducts the heat of the monocrystalline silicon rod to the furnace body.

Optionally, the heat conduction tool is arranged on each of an inner surface and an outer surface of the cylinder; and
the heat conduction tool on the inner surface of the cylinder is configured to contact with the monocrystalline silicon rod, and the heat conduction tool on the outer surface of the cylinder is configured to contact with the furnace body.

Optionally, the single crystal furnace further includes a rotary assembly; and
the rotary assembly is connected to the furnace body, and is configured to drive the heat transfer member to rotate relative to the furnace body.

Optionally, the rotary assembly includes an outer stator and an inner rotor;
the outer stator is fixedly connected to the furnace body, and the inner rotor is arranged in the outer stator and is rotatably connected to the outer stator; and
the inner rotor is configured to drive the heat transfer member to rotate relative to the furnace body.

Optionally, the rotary assembly includes a rotary ring and a slewing transmission mechanism;
the slewing transmission mechanism is fixedly connected to the furnace body, and is configured to drive the rotary ring to rotate relative to the furnace body; and
the rotary ring is configured to drive the heat transfer member to rotate relative to the furnace body.

Optionally, the furnace body includes a primary furnace chamber, a secondary furnace chamber, and an isolation valve;
the isolation valve is connected between the primary furnace chamber and the secondary furnace chamber; and
the rotary assembly is arranged between the isolation valve and the primary furnace chamber, or the rotary assembly is arranged between the isolation valve and the secondary furnace chamber.

Optionally, a heat transfer structure dissipation structure is provided in a side wall of the secondary furnace chamber.

Optionally, the heat conduction tool includes a plurality of heat conduction assemblies;
the plurality of heat conduction assemblies are arranged along a length direction of the heat transfer member and are connected to the heat transfer member; and
each of the heat conduction assemblies includes a telescopic member and a heat conduction member, the telescopic member is connected to the heat transfer member, and the heat conduction member is fixedly connected to an end of the telescopic member.

Optionally, the furnace body includes a furnace chamber, the furnace chamber is configured for growing the monocrystalline silicon rod, and the heat conduction member is configured to abut against a surface of the monocrystalline silicon rod; and
the heat transfer member is arranged in the furnace chamber along an axial direction of the furnace body, and the axial direction of the furnace body is parallel to a length direction of the heat transfer member.

Optionally, the furnace chamber includes a secondary furnace chamber, and the heat transfer member includes a first heat conduction portion;
each of the heat conduction assemblies connected to the first heat conduction portion includes two heat conduction members, and the two heat conduction members are connected to two ends of the telescopic member; and
one of the heat conduction members is configured to abut against the surface of the monocrystalline silicon rod, and the other heat conduction member is configured to abut against the side wall of the secondary furnace chamber.

Optionally, the furnace chamber further includes a primary furnace chamber, the heat transfer member further includes a second heat conduction portion, and the second heat conduction portion and the first heat conduction portion are integrally formed; and

The heat conduction assembly connected to the second heat conduction portion includes one heat conduction member, and the heat conduction member is configured to abut against the surface of the monocrystalline silicon rod.

Optionally, the side wall of the secondary furnace chamber is a double-layer wall structure, including an inner wall and an outer wall; and
a cooling medium is filled between the inner wall and the outer wall, and the inner wall abuts against the heat conduction member.

Optionally, the heat transfer member is of a cylindrical structure, the cylindrical structure surrounds a circumferential side of the monocrystalline silicon rod, and the heat conduction member is at least distributed on an inner side of the cylindrical structure.

An embodiment of this application also provides a heat conduction tool, including a heat transfer member and a plurality of heat conduction assemblies, where
the plurality of heat conduction assemblies are arranged along a length direction of the heat transfer member and are connected to the heat transfer member; and
each of the heat conduction assemblies includes a telescopic member and a heat conduction member, the telescopic member is connected to the heat transfer member, and the heat conduction member is fixedly connected to an end of the telescopic member.

Optionally, the heat conduction member is of a spherical structure.

Optionally, the telescopic member is a spring or a telescopic rod.

Optionally, an arrangement direction of the telescopic member is inclined relative to the length direction of the heat transfer member.

An embodiment of this application also provides a crystal pulling temperature control method for a single crystal furnace, where a heat transfer assembly rotatable relative to a furnace body of the single crystal furnace is arranged in the furnace body, the method including:
conducting heat of the monocrystalline silicon rod through the heat transfer assembly when the monocrystalline silicon rod is in contact with the heat transfer assembly, where, a rotational speed of the heat transfer assembly is the same as a rotational speed of the monocrystalline silicon rod.

In the single crystal furnace of the embodiment of this application, the single crystal furnace includes a furnace body and a heat transfer assembly, and the heat transfer assembly is arranged in the furnace body. In an initial stage of crystal pulling, the monocrystalline silicon rod is short, and the heat transfer member is not in contact with the monocrystalline silicon rod. As the crystal pulling proceeds, the monocrystalline silicon rod grows longer and the monocrystalline silicon rod gradually ascends. When the monocrystalline silicon rod gradually comes into contact with the heat transfer assembly, heat of the monocrystalline silicon rod can be conducted to the heat transfer assembly. In the single crystal furnace, because the heat of the monocrystalline silicon rod can be transferred to an inner surface of the furnace body through the solid-state heat transfer assembly and dissipated to the outside through the furnace body, the temperature of the monocrystalline silicon rod can be rapidly lowered, so that the crystal pulling speed can be further increased. In addition, the risk of collision around the monocrystalline silicon rod in the single crystal furnace can be avoided. Therefore, the single crystal furnace can achieve both a high crystal pulling speed and high crystal pulling quality.

The above description is only a summary of the technical solutions of this application. To make the technical means of this application clearer and implementable in accordance with the disclosure of the specification, and to make the above objectives, features and advantages of this application more comprehensible, specific implementations of this application are provided below.

### BRIEF DESCRIPTION OF THE DRAWINGS

To describe the technical solutions of the embodiments of this application or the related art more clearly, the following briefly introduces the accompanying drawings required for describing the embodiments or the prior art. Apparently, the accompanying drawings in the following description show only some embodiments of this application, and a person of ordinary skill in the art may still derive other drawings from these accompanying drawings without creative efforts.
FIG. 1 is a schematic diagram showing a monocrystalline silicon rod and a heat transfer assembly which are not in contact with each other during crystal pulling in a single crystal furnace according to an embodiment of this application;
FIG. 2 is a schematic diagram showing a monocrystalline silicon rod and a heat transfer assembly which are in contact with each other during crystal pulling in a single crystal furnace according to an embodiment of this application;
FIG. 3 is a schematic diagram of a heat transfer member according to an embodiment of this application;
FIG. 4 is a schematic diagram of a heat transfer assembly formed by fixing a heat conduction tool on an inner surface of a furnace body of a single crystal furnace according to an embodiment of this application;
FIG. 5 is a schematic diagram showing a heat transfer member in a suspended state in a single crystal furnace according to an embodiment of this application;
FIG. 6 is a schematic diagram showing a head of a monocrystalline silicon rod in contact with a heat transfer member in a single crystal furnace according to an embodiment of this application;
FIG. 7 is a schematic diagram showing a monocrystalline silicon rod pushing a heat transfer member to move in a single crystal furnace according to an embodiment of this application;
FIG. 8 is a schematic diagram of another heat transfer member according to an embodiment of this application;
FIG. 9 is a three-dimensional schematic diagram of a heat transfer member according to an embodiment of this application;
FIG. 10 is a schematic diagram of another heat transfer member according to an embodiment of this application;
FIG. 11 is a partially enlarged schematic view of part I in FIG. 10 according to an embodiment of this application;
FIG. 12 is a schematic diagram of a heat transfer assembly formed by fixing a heat conduction tool on both an inner surface and an outer surface of a heat transfer member in a single crystal furnace according to an embodiment of this application;
FIG. 13 is a schematic diagram of a heat conduction tool including one heat conduction member according to an embodiment of this application;
FIG. 14 is a schematic diagram of a heat conduction tool including two heat conduction members according to an embodiment of this application;
FIG. 15 is a schematic diagram of a single crystal furnace according to an embodiment of this application;
FIG. 16 is a partially enlarged schematic view of a secondary chamber of a single crystal furnace according to an embodiment of this application; and
FIG. 17 is a schematic diagram of another single crystal furnace according to an embodiment of this application.

List of reference numerals:
furnace body-10, heat transfer assembly-11, lifting assembly-12, rotary assembly-13, monocrystalline silicon rod-20, primary furnace chamber-101, secondary furnace chamber-102, inner wall-1021, outer wall-1022, isolation valve-103, heat transfer member-111, heat conduction tool-112, a telescopic member-1121, heat conduction member-1122, first heat conduction portion-1114, support portion-1123, second heat conduction portion-1115, outer stator-131, inner rotor-132, cylinder-1111, flange-1112, pressing plate-1113, first through hole-1131, second through hole-1121.

### DETAILED DESCRIPTION

To make the objectives, technical solutions and advantages of the embodiments of this application clearer, the technical solutions in the embodiments of this application will be described clearly and thoroughly with reference to the accompanying drawings in the embodiments of this application. Apparently, the embodiments described are merely some embodiments, rather than all of the embodiments of this application. All other embodiments obtained by a person of ordinary skill in the art based on the embodiments of this application without making creative efforts shall fall within the protection scope of this application.

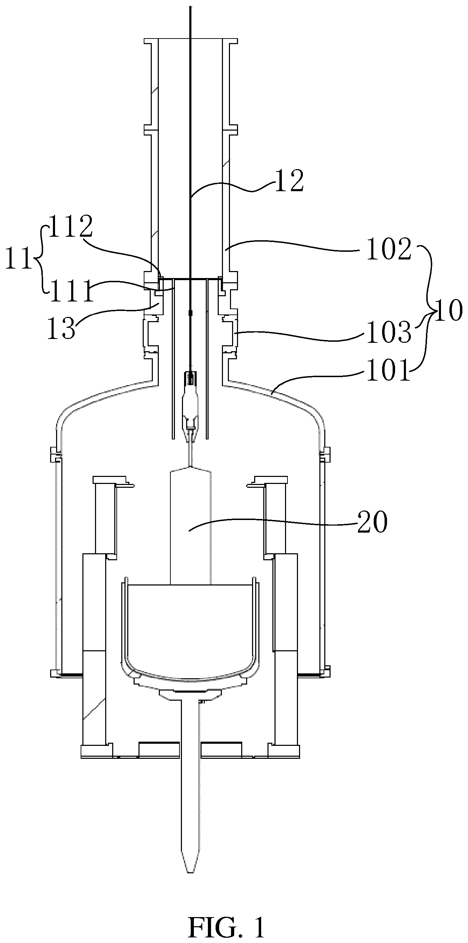

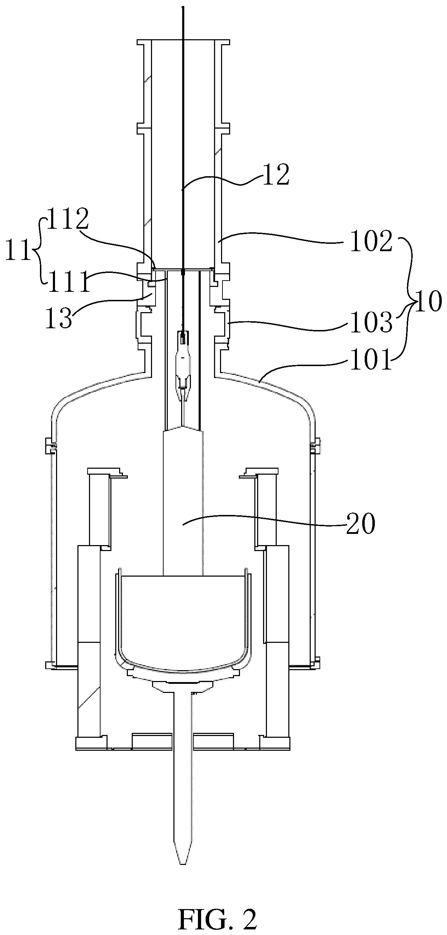

FIG. 1 and FIG. 2 show a single crystal furnace according to an embodiment of this application. The single crystal furnace includes a furnace body 10 and a heat transfer assembly 11. The furnace body 10 is configured to grow a monocrystalline silicon rod 20.

In an axial direction of the furnace body 10, the heat transfer assembly 11 is arranged in the furnace body 10.

The heat transfer assembly 11 is configured to contact with the monocrystalline silicon rod 20 and conduct heat of the monocrystalline silicon rod 20.

Specifically, the single crystal furnace according to the embodiment of this application is a crystal pulling equipment for use in manufacturing of monocrystalline silicon rods. As shown in FIG. 1 and FIG. 2, the single crystal furnace includes the furnace body 10 and the heat transfer assembly 11. The furnace body 10 is a container in which a crucible is placed, a closed space can be formed in the furnace body 10, and a silicon material in the crucible can be heated and melted. As shown in FIG. 1, the heat transfer assembly 11 is a solid heat conduction medium arranged in the furnace body 10.

As shown in FIG. 1 or FIG. 2, it can be understood that in the single crystal furnace, the monocrystalline silicon rod 20 that continuously grows and becomes longer may be lifted by a lifting assembly 12, and the lifting assembly 12 may also provide rotational power for the monocrystalline silicon rod 20 during the growth of the monocrystalline silicon rod 20. The lifting assembly 12 includes a tungsten wire and a counterweight attached to an end of the tungsten wire, and a seed crystal is fixed to the counterweight. The lifting assembly 12 extends into the crucible through a hollow part of the heat transfer assembly 11, and the seed crystal enters into contact with the liquid silicon in the crucible. As the lifting assembly 12 rotates and lifts up the monocrystalline silicon rod 20, a cylindrical monocrystalline silicon rod 20 is gradually formed.

It should be noted that, as shown in FIG. 1, in an initial stage of crystal pulling, since the monocrystalline silicon rod 20 is short, the monocrystalline silicon rod 20 is not in contact with the heat transfer assembly 11. As the crystal pulling proceeds, the lifting assembly 12 gradually lifts up the monocrystalline silicon rod 20, and the monocrystalline silicon rod 20 gradually grows and becomes longer. As shown in FIG. 2, when the monocrystalline silicon rod 20 comes into contact with the heat transfer assembly 11, heat of the monocrystalline silicon rod 20 is conducted to a heat transfer member 111 having excellent thermal conductivity. Before the crystal pulling is completed, the heat of the monocrystalline silicon rod 20 can be continuously conducted to the furnace body 10 through the heat transfer assembly 11, and then dissipated to the outside through the furnace body 10.

In the single crystal furnace according to the embodiment of this application, because the heat of the monocrystalline silicon rod can be transferred to an inner surface of the furnace body through the solid-state heat transfer assembly and dissipated to the outside through the furnace body, such a contact-type heat exchange structure can quickly reduce the temperature of the monocrystalline silicon rod compared with conventional contactless heat exchange structures, and can further increase the crystal pulling speed. The crystal pulling speed can be increased to 3.0 mm/min according to calculation. Moreover, the monocrystalline silicon rod does not suffer any collision in the single crystal furnace, so that the risk of wire breakage defects can be reduced. Therefore, this single crystal furnace can achieve both a high crystal pulling speed and high crystal pulling quality.

Optionally, referring to FIG. 1 to FIG. 4, the heat transfer assembly 11 includes a heat transfer member 111, and the heat transfer member 111 includes a cylinder 1111 arranged in the furnace body 10.

The cylinder 1111 is configured to contact with the monocrystalline silicon rod 20 and conduct the heat of the monocrystalline silicon rod 20.

Specifically, as shown in FIG. 1 or FIG. 2, the heat transfer assembly 11 may include the heat transfer member 111, and the heat transfer member 111 may be a heat conductor made of a carbon-carbon material or graphite material. In the axial direction of the furnace body 10, the heat transfer member 111 is arranged in the furnace body 10, and a side surface of the heat transfer member 111 may be in direct or indirect contact with the inner surface of the furnace body 10 to realize the conduction and transfer of heat. When the monocrystalline silicon rod 20 is in contact with the heat transfer member 111, the heat transfer member 111 can conduct heat from the monocrystalline silicon rod 20 to the furnace body 10.

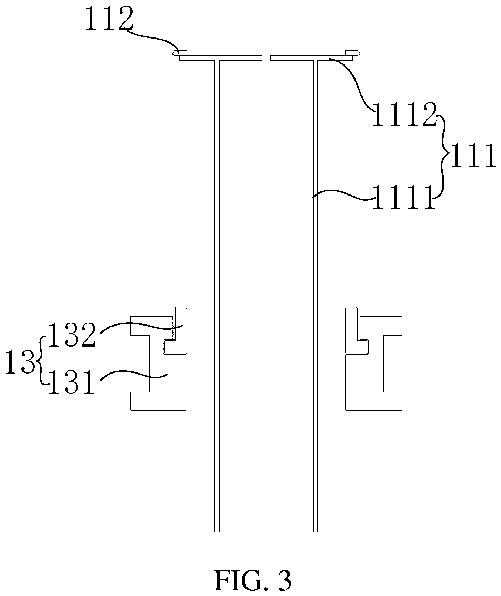

As shown in FIG. 3, the heat transfer member 111 includes a cylinder 1111 arranged in the furnace body 10. The cylinder 1111 has a hollow channel running through the cylinder 1111 along an axial direction of the cylinder 1111, which can facilitate the arrangement and assembly of the lifting assembly 12. The lifting assembly 12 passes through the cylinder 1111 to realize the lifting of the monocrystalline silicon rod 20.

Optionally, referring to FIG. 1 to FIG. 4, the heat transfer assembly 11 further includes a heat conduction tool 112, and the heat conduction tool 112 is arranged on the heat transfer member 111 and/or on the inner surface of the furnace body 10.

Specifically, in an implementation, in order to avoid rigid contact between the solid-state heat transfer member 111 and the furnace body 10 and improve the service life of the heat transfer member 111, the heat conduction tool 112 may be arranged between a surface of the heat transfer member 111 and the inner surface of the furnace body 10. The heat conduction tool 112 may be a fiber bundle-shaped brush made of a carbon-carbon material or graphite material, or the heat conduction tool 112 may be a viscous thermally conductive silicone grease or the like applied between the surface of the heat transfer member 111 and the inner surface of the furnace body 10. It should be noted that the surface of the heat transfer member 111 may at least include an outer surface of the heat transfer member 111 in contact with the furnace body 10, and may also include an inner surface of the heat transfer member 111 in contact with the monocrystalline silicon rod 20.

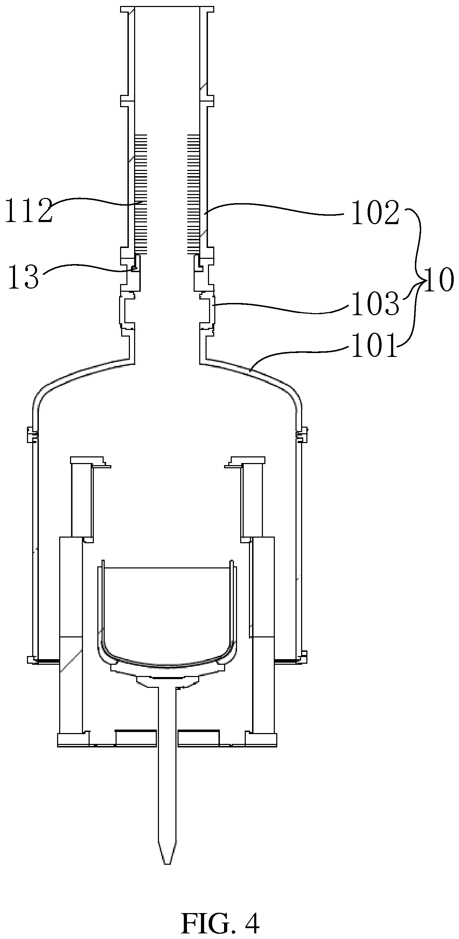

As shown in FIG. 1 to FIG. 3, in an example where the heat conduction tool 112 is a brush, when the heat conduction tool 112 is fixed to the heat transfer member 111, the heat conduction tool 112 may be connected to an outer surface of the heat transfer member 111, and an end portion of the heat conduction tool 112 is in flexible contact with the inner surface of the furnace body 10. As shown in FIG. 4, when the heat conduction tool 112 is fixed to the inner surface of the furnace body 10, the end portion of the heat conduction tool 112 is in flexible contact with the heat transfer member 111. The softness and flexibility of the heat conduction tool 112 can reduce the resistance between the heat transfer member 111 and the furnace body 10, and can avoid wear caused by the rigid contact between the heat conduction tool 112 and the furnace body 10, thereby prolonging the service life of the heat transfer member 111. Of course, the heat conduction tool 112 may also be connected to the outer surface of the heat transfer member 111 and the inner surface of the furnace body 10 at the same time, and the parts of the heat conduction tool 112 at the two positions may be in contact with each other.

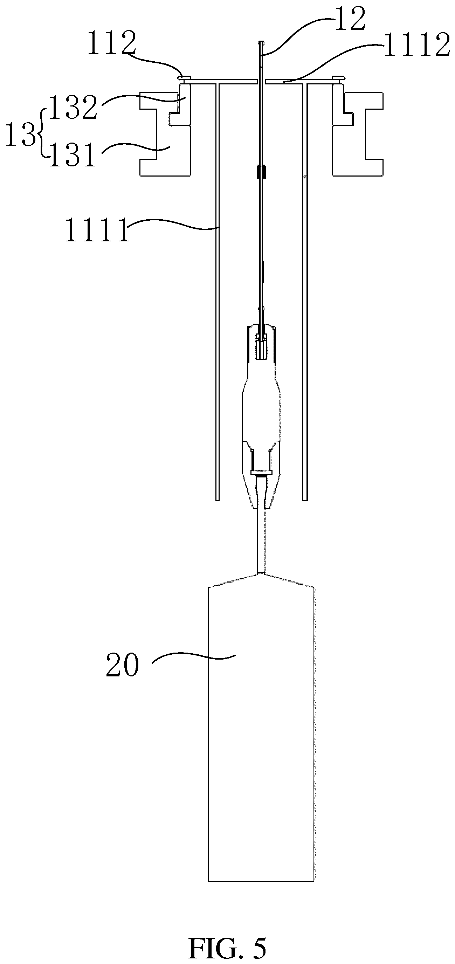

Optionally, referring to FIG. 5 to FIG. 7, an inner diameter of the cylinder 1111 is smaller than a diameter of the monocrystalline silicon rod 20.

The heat transfer member 11 further includes a flange 1112 arranged on an outer surface of the cylinder 1111, the flange 1112 radially extends in a direction away from an axis of the cylinder 1111, and the flange 1112 is configured to abut against and fit with the furnace body 10.

A head of the monocrystalline silicon rod 20 is in contact with an end portion of the cylinder 1111 to push the flange 1112 to separate from the furnace body 10.

Specifically, as shown in FIG. 5 to FIG. 7, in an implementation, the inner diameter of the cylinder 1111 of the heat transfer member 111 may be designed to be smaller than the diameter of the monocrystalline silicon rod 20. It can be easily understood that because the monocrystalline silicon rod 20 is gradually lifted up in the crystal pulling process, the monocrystalline silicon rod 20 can push the cylinder 1111 upward when the inner diameter of the cylinder 1111 of the heat transfer member 111 is smaller than the diameter of the monocrystalline silicon rod 20. Furthermore, in the heat transfer assembly 11, in order to make the heat transfer member 111 stably and reliably stay at an initial mounting position in the furnace body 10 when the monocrystalline silicon rod 20 is not in contact with the heat transfer member 111, the flange 1112 is arranged on the outer surface of the cylinder 1111. The flange 1112 may be a continuous annular flange circumferentially surrounding the outer surface of the cylinder 1111 or a plurality of flanges arranged at intervals. The flange 1112 may be fixed to the cylinder 1111 by a structural adhesive, or the flange 1112 and the cylinder 1111 may be integrally formed. The flange 1112 radially extends in the direction away from the axis of the cylinder 1111 and protrudes from the outer surface of the cylinder 1111, and an overall dimension of the flange 1112 is larger than the outer diameter of the cylinder 1111. The flange 1112 and a corresponding part of the inner surface of the furnace body 10 have an overlapping region in a radial direction of the furnace body 10, so that when the heat transfer member 111 is inserted into the furnace body 10, the flange 1112 abuts against and fits with the furnace body 10 under gravity, and the heat transfer member 111 can temporarily stay at the initial mounting position in the furnace body 10. The initial mounting position is an initial position of the heat transfer member 111 in the furnace body 10 when the heat transfer member 111 has not received a pushing force from the monocrystalline silicon rod 20. It should be noted that the flange 1112 may be arranged at an end portion of the cylinder 1111 or at any position between two end portions of the cylinder 1111.

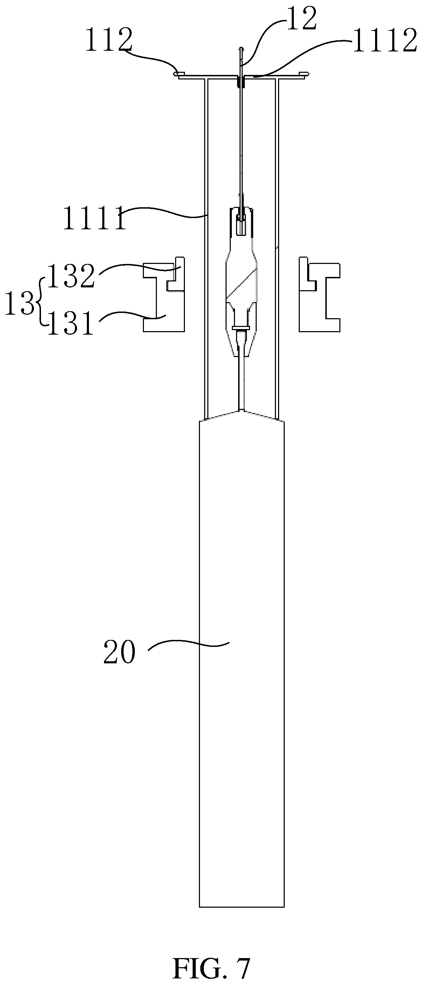

With the use of the heat transfer member 111 of this configuration, as shown in FIG. 5 to FIG. 6, when the lifting assembly 12 drives the monocrystalline silicon rod 20 to ascend, the head of the monocrystalline silicon rod 20 is in contact with one end of the cylinder 1111, and the cylinder 1111 is pushed upward by the monocrystalline silicon rod 20 below the cylinder 1111. As shown in FIG. 7, as the lifting assembly 12 continuously lifts up the monocrystalline silicon rod 20, the monocrystalline silicon rod 20 pushes the cylinder 1111 to move upward in the furnace body 10 together, so that the flange 1112 is separated from the furnace body 10, the heat transfer member 111 gradually leaves the initial installation position, and the side surface of the heat transfer member 111 is continuously in contact with and slides on the inner surface of the furnace body 10, until the crystal pulling is completed. It should be noted that the head of the monocrystalline silicon rod 20 in the embodiment of this application refers to a portion whose diameter increases immediately adjacent to the seed crystal, and has an end surface exposed to the outside with respect to the seed crystal, where the end surface is inclined at an angle with respect to a central axis of the seed crystal.

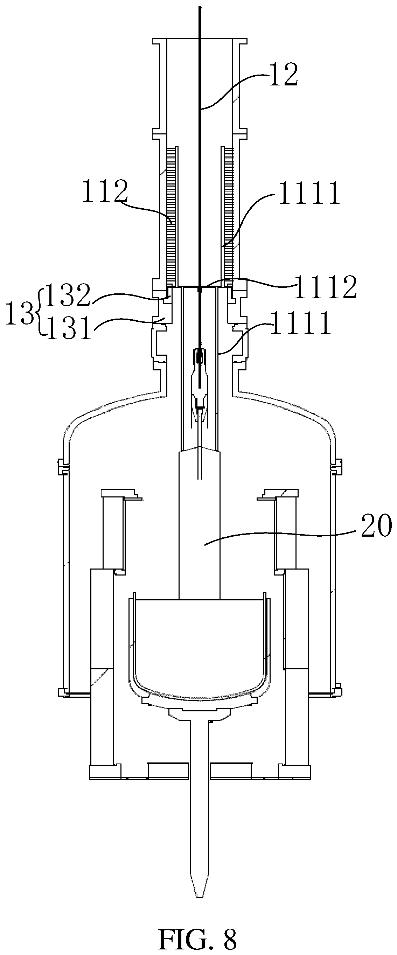

Of course, in another implementation, as shown in FIG. 8, the cylinder 1111 may also extend upward and downward at the same time, an inner diameter of the downward extending portion of the cylinder 1111 is smaller than the diameter of the monocrystalline silicon rod 20, and the downward extending portion of the cylinder 1111 extends to a position close to the surface of the silicon liquid. An inner diameter of the upward extending portion of the cylinder 1111 may be larger than the diameter of the monocrystalline silicon rod 20, and an outer surface of the upward extending portion of the cylinder 1111 may be fixedly connected to the heat conduction tool 112.

Optionally, referring to FIG. 1 to FIG. 4, the heat conduction tool 112 is fixed to the outer surface of the heat transfer member 111, and/or the heat conduction tool 112 is fixed to the inner surface of the furnace body 10.

Specifically, as shown in FIG. 1 to FIG. 3, in an example where the heat conduction tool 112 is a brush, when the heat conduction tool 112 is fixed to the heat transfer member 111, the heat conduction tool 112 may be connected to an outer surface of the heat transfer member 111, and an end portion of the heat conduction tool 112 is in flexible contact with the inner surface of the furnace body 10. As shown in FIG. 4, when the heat conduction tool 112 is fixed to the inner surface of the furnace body 10, the end portion of the heat conduction tool 112 is in flexible contact with the heat transfer member 111. The softness and flexibility of the heat conduction tool 112 can reduce the resistance between the heat transfer member 111 and the furnace body 10, and can avoid wear caused by the rigid contact between the heat conduction tool 112 and the furnace body 10, thereby prolonging the service life of the heat transfer member 111. Of course, the heat conduction tool 112 may also be connected to the outer surface of the heat transfer member 111 and the inner surface of the furnace body 10 at the same time, and the parts of the heat conduction tool 112 at the two positions may be in contact with each other.

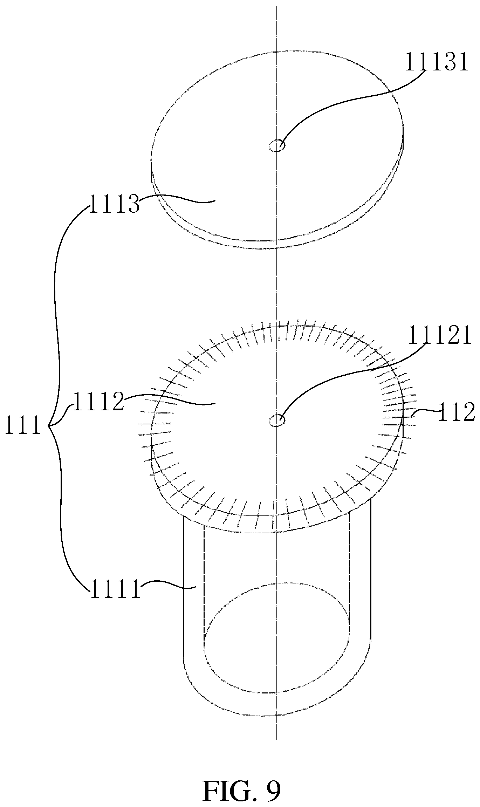

Optionally, referring to FIG. 9, the heat transfer member 111 further includes a pressing plate 1113.

The heat conduction tool 112 is arranged on a surface of the flange 1112 facing away from the monocrystalline silicon rod 20 along a circumferential direction of the flange 1112, and the pressing plate 1113 is stacked on the flange 1112 to retain and fix the heat conduction tool 112.

Specifically, in an implementation, as shown in FIG. 9, the heat transfer member 111 may further include a pressing plate 1113, and the pressing plate 1113 and the flange 1112 can cooperate to fix the heat conduction tool 112.

FIG. 9 shows a structure of the heat transfer member 111 in which the flange 1112 is arranged at an end portion of the cylinder 1111. The flange 1112 may be a circular plate-like structure, and the diameter of the flange 1112 is larger than the diameter of the cylinder 1111, so that the portion of the flange 1112 extending beyond an edge of the cylinder 1111 can abut against and fit with the furnace body 10. The flange 1112 may be fixedly adhered to the end portion of the cylinder 1111 by a heat-resistant structural adhesive or may be tightened by a carbon-carbon bolt. The heat conduction tool 112 may be fixed to a surface of the flange 1112 by a heat-resistant structural adhesive, and then pressed from one side by the pressing plate 1113 and thus fixed. The pressing plate 1113 may be fastened to the flange 1112 by a carbon-carbon bolt, which is also convenient for subsequent maintenance and replacement of the heat conduction tool 112.

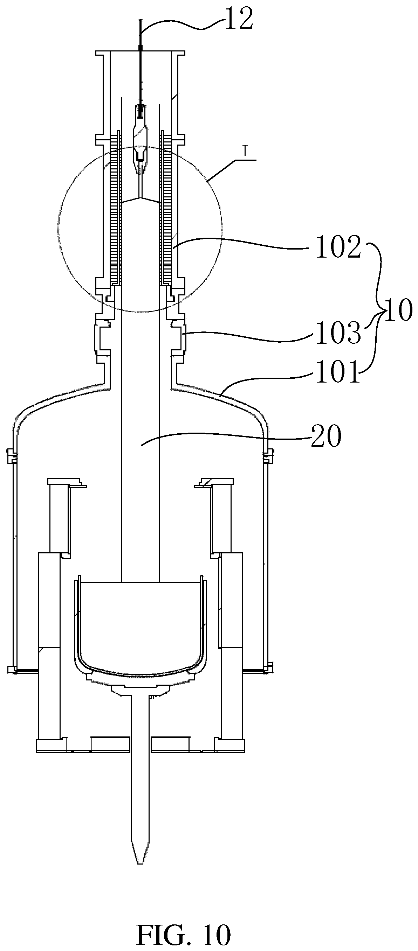

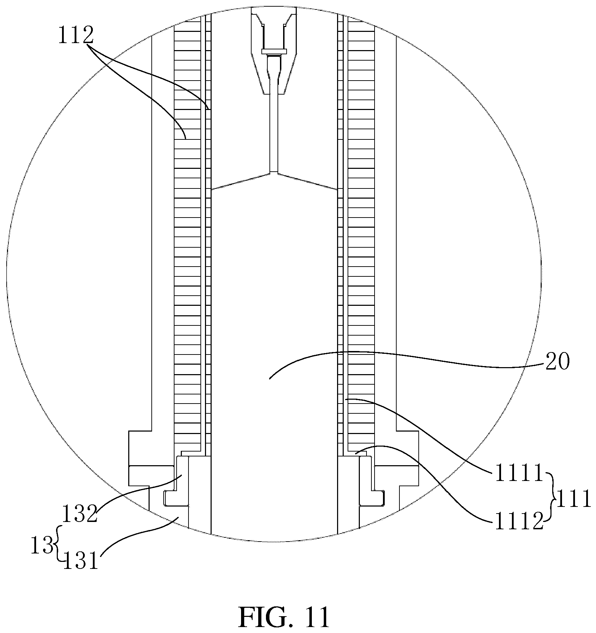

Optionally, referring to FIG. 10 and FIG. 11, the inner diameter of the cylinder 1111 is larger than the diameter of the monocrystalline silicon rod 20.

The monocrystalline silicon rod 20 passes through the cylinder 1111, and the cylinder 1111 conducts the heat of the monocrystalline silicon rod 20 to the furnace body 10.

Specifically, as shown in FIG. 10 and FIG. 11, in an implementation, the inner diameter of the cylinder 1111 of the heat transfer member 111 may also be designed to be larger than the diameter of the monocrystalline silicon rod 20. With the use of the heat transfer member 111 of this configuration, when the lifting assembly 12 drives the monocrystalline silicon rod 20 to ascend, the monocrystalline silicon rod 20 can pass through the cylinder 1111. As the lifting assembly 12 continuously lifts up the monocrystalline silicon rod 20, the overlapping region between the side surface of the monocrystalline silicon rod 20 and the inner surface of the cylinder 1111 gradually increases, until the crystal pulling is completed. The side surface of the monocrystalline silicon rod 20 may be in contact with the inner surface of the cylinder 1111 to realize the conduction of heat. It can be understood that when the heat transfer member 111 of this configuration is used, the heat transfer assembly 11 does not ascend along with the monocrystalline silicon rod 20, but is in contact with the monocrystalline silicon rod 20 at a fixed position. In this way, the heat transfer assembly can extend downward to the vicinity of the surface of the liquid silicon, which helps shorten the heat conduction path and greatly increase the heat conduction area, and can provide a larger contact area for heat conduction between the monocrystalline silicon rod 20 and the cylinder 1111, to achieve more rapid heat conduction.

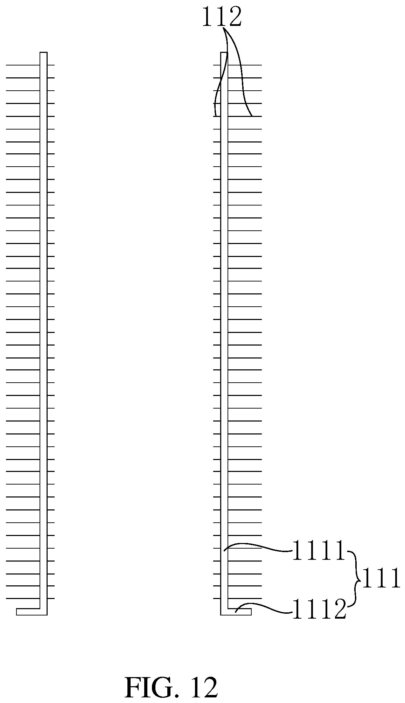

Optionally, referring to FIG. 12, the heat conduction tool 112 is arranged on each of the inner surface and an outer surface of the cylinder 1111.

The heat conduction tool on the inner surface of the cylinder 1111 is configured to contact with the monocrystalline silicon rod 20, and the heat conduction tool on the outer surface of the cylinder 111 is configured to contact with the furnace body 10.

Specifically, in an implementation, as shown in FIG. 12, when the monocrystalline silicon rod 20 can pass through the cylinder 1111, the heat conduction tool 112 may be fixed to both the inner surface and the outer surface of the cylinder 1111. The heat conduction tool on the inner surface of the cylinder 1111 is in contact with the monocrystalline silicon rod 20 to conduct the heat of the monocrystalline silicon rod 20 to the cylinder 1111. The heat conduction tool 112 on the outer surface of the cylinder 1111 is in contact with the furnace body 10 to conduct heat of the cylinder 1111 to the furnace body 10. The arrangement of the heat conduction tool 112 both inside and outside the cylinder 1111 helps prolong the service life of the heat transfer member.

Optionally, referring to FIG. 1 or FIG. 2, the single crystal furnace further includes a rotary assembly 13.

The rotary assembly 13 is connected to the furnace body 10, and is configured to drive the heat transfer member 111 to rotate relative to the furnace body 10.

Specifically, in an implementation, the monocrystalline silicon rod 20 is always in a rotating state during the crystal pulling growth process. If the heat transfer assembly 11 is in a static state, and the monocrystalline silicon rod 20 comes into contact with the heat transfer assembly 11, the weight of the heat transfer assembly 11 is applied to the monocrystalline silicon rod 20 and the lifting assembly 12. Due to the difference between the rotational speeds of the monocrystalline silicon rod 20 and the lifting assembly 12, the soft tungsten wire in the lifting assembly 12 is twisted under the inertia action of the heat transfer assembly 11, which is likely to cause a fluctuation of the rotational speed of the monocrystalline silicon rod 20, resulting in wire breakage during crystal pulling. Therefore, as shown in FIG. 1 or FIG. 2, an embodiment of this application also provides a rotary assembly 13 mounted on the furnace body 10, the heat transfer member 111 can be in contact with a rotating member in the rotary assembly 13 when inserted into the furnace body 10, and the heat transfer member 111 is in friction transmission with the rotating member. When the rotary assembly 13 operates, the rotating member in the rotary assembly 13 can drive the heat transfer assembly 11 to rotate together, so that the heat transfer assembly 11 has a certain rotational speed. Therefore, when the monocrystalline silicon rod 20 in the rotating state comes into contact with the heat transfer assembly 11, the difference between the rotational speeds of the monocrystalline silicon rod 20 and the heat transfer assembly 11 is small, and the fluctuation of the rotational speed of the monocrystalline silicon rod 20 is small, so that the risk of wire breakage during crystal pulling can be reduced.

In addition, it should be noted that when the rotary assembly 13 is used to drive the heat transfer member 111 to rotate, the flange 1112 in the heat transfer member 111 may be in contact with the rotating member in the rotary assembly 13, so that the cylinder 1111 extends toward the surface of the liquid silicon through the rotary assembly 13. Of course, the cylinder 1111 may also extend away from the surface of the liquid silicon without passing through the rotary assembly 13. In practical applications, a specific design and mounting scheme may be determined according to the structures of the rotary assembly 13 and the heat transfer member 111 and the space in the furnace body 10 as long as the heat transfer member 111 can be driven to rotate, and is not limited in the embodiments of this application.

Optionally, referring to FIG. 3, the rotary assembly 13 includes an outer stator 131 and an inner rotor 132.

The outer stator 131 is fixedly connected to the furnace body 10. The inner rotor 132 is arranged in the outer stator 131 and is rotatably connected to the outer stator 131.

The inner rotor 132 is configured to drive the heat transfer member 111 to rotate relative to the furnace body 10.

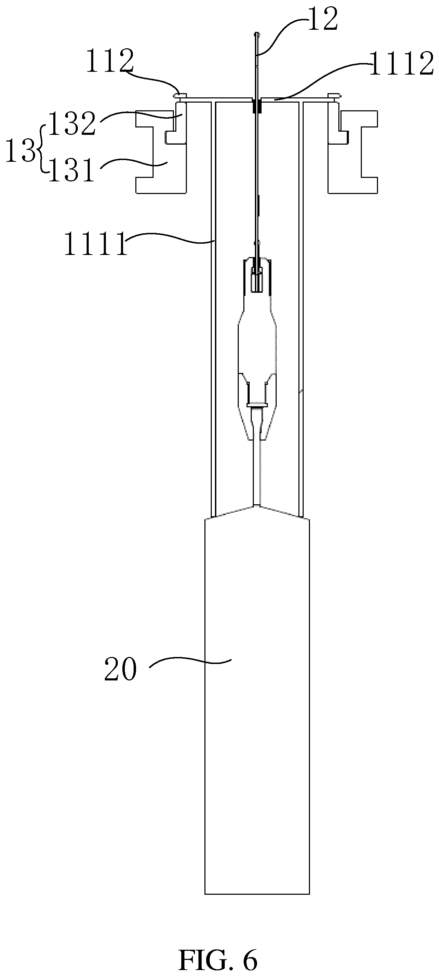

Specifically, in an implementation, as shown in FIG. 3, the rotary assembly 13 may be a hollow motor with power, and the hollow motor includes an outer stator 131 and an inner rotor 132. Both the outer stator 131 and the inner rotor 132 are of a hollow structure. The outer stator 131 is fixedly connected to the furnace body 10. The inner rotor 132 is arranged in the outer stator 131 and is rotatably connected to the outer stator 131. The outer stator 131 and the inner rotor 132 rotate by the principle of electromagnetic induction. As shown in FIG. 6, the heat transfer assembly 11 may pass through the hollow portion of the inner rotor 132, and the inner rotor 132 supports the heat transfer assembly 11 in a suspended state. FIG. 7 further shows a schematic diagram when the monocrystalline silicon rod 20 in the rotating state comes into contact with the heat transfer assembly 11. FIG. 8 further shows a schematic diagram of the monocrystalline silicon rod 20 growing upward to push the heat transfer assembly 11 to move upward to separate from the inner rotor 132. After the heat transfer assembly 11 is separated from the inner rotor 132, the rotational power of the heat transfer assembly 11 comes from the lifting assembly 12 that drives the monocrystalline silicon rod 20 to rotate. Therefore, when the inner rotor 132 rotates relative to the outer stator 131, the inner rotor 132 can drive the heat transfer assembly 11 to rotate together, until the heat transfer assembly 11 is separated from the inner rotor 132 and rotates under the drive of the lifting assembly 12. Such a hollow motor has its own driving power, has high rotational precision, can precisely control the speed of the heat transfer assembly 11, has a simple structure, and can be conveniently mounted by connecting the outer stator 131 to the furnace body 10.

Optionally, the rotary assembly 13 includes a rotary ring and a slewing transmission mechanism.

The slewing transmission mechanism is fixedly connected to the furnace body 10, and is configured to drive the rotary ring to rotate relative to the furnace body 10.

The rotary ring is configured to drive the heat transfer member 111 to rotate relative to the furnace body 10.

Specifically, in an implementation, the rotary assembly 13 may also be driven by an external drive motor outside the furnace body 10, and the rotary assembly 13 may include a rotary ring and a slewing transmission mechanism. The slewing transmission mechanism may be a gear transmission mechanism, a sprocket transmission mechanism, a worm gear transmission mechanism, or the like. The slewing transmission mechanism is fixedly connected to the furnace body 10. An output end of the slewing transmission mechanism is connected to the rotary ring. The rotary ring may be mounted in the furnace body 10. The rotary ring can support the rotary assembly 13. When the heat transfer member 111 is inserted into the furnace body 10, the heat transfer member 111 may abut against the rotary ring, and the heat transfer member 111 is in friction transmission with the rotary ring.

When the external drive motor drives the slewing transmission mechanism to move, the slewing transmission mechanism may further drive the rotary ring in the furnace body 10 to rotate, so that the heat transfer member 111 rotates at a rotational speed close to that of the monocrystalline silicon rod 20. Because the rotary assembly 13 using external power can be driven by a conventional motor, it is only necessary to design and manufacture the slewing transmission mechanism and the rotary ring to be mounted in the furnace body 10. Methods of processing and manufacturing these structures are more mature and simpler, so the manufacturing cost of the rotary assembly 13 of this configuration is lower than that of the hollow motor described above.

Optionally, referring to FIG. 9, the pressing plate 1113 is provided with a first through hole 11131, the flange 1112 is provided with a second through hole 11121, the first through hole 11131 and the second through hole 11121 are coaxial, and the lifting assembly 12 passes through the first through hole 11131 and the second through hole 11121.

Specifically, in an implementation, as shown in FIG. 9, the pressing plate 1113 is provided with a first through hole 11131, the flange 1112 is provided with a second through hole 11121, and the first through hole 11131 and the second through hole 11121 are coaxial. The lifting assembly 12 may pass through the two through holes and out of the cylinder 1111 and then extend to a position close to the crucible in the furnace. For example, diameters of the two through holes are slightly larger than a diameter of the tungsten wire in the lifting assembly 12. Therefore, the two through holes can radially limit the lifting assembly 12, to reduce the risk of deflection of the lifting assembly 12 during rotation, making the crystal pulling process more stable.

Optionally, referring to FIG. 1 or FIG. 2, the furnace body 10 includes a primary furnace chamber 101, a secondary furnace chamber 102, and an isolation valve 103.

The isolation valve 103 is connected between the primary furnace chamber 101 and the secondary furnace chamber 102.

The rotary assembly 13 is arranged between the isolation valve 103 and the primary furnace chamber 101, or the rotary assembly 13 is arranged between the isolation valve 103 and the secondary furnace chamber 102.

Specifically, in an implementation, as shown in FIG. 1 or FIG. 2, the single crystal furnace includes a primary furnace chamber 101, a secondary furnace chamber 102, and an isolation valve 103. The isolation valve 103 is connected between the primary furnace chamber 101 and the secondary furnace chamber 102. When the isolation valve 103 is open, the primary furnace chamber 101 and the secondary furnace chamber 102 are in communication with each other. When the isolation valve 103 is closed, the primary furnace chamber 101 and the secondary furnace chamber 102 are separated from each other to form two sealed chambers, so that the sealing requirements during secondary feeding in the crystal pulling process and during removal of the monocrystalline silicon rod can be met. In the single crystal furnace, the rotary assembly 13 may be mounted between the isolation valve 103 and the secondary furnace chamber 102. In this case, the rotary assembly 13 is far away from the primary furnace chamber 101, and the high temperature environment of the primary furnace chamber 101 has a weak thermal influence on the rotary assembly 13. As such, especially when a hollow motor is used as the rotary assembly 13, the requirement on the heat resistance of the hollow motor can be appropriately reduced, thus reducing the difficulty of selection and design. Of course, when the rotary assembly 13 has good heat resistance, the rotary assembly 13 may also be mounted between the isolation valve 103 and the primary furnace chamber 101. In this case, when the rotary assembly 13 drives the heat transfer assembly 11, the heat transfer assembly 11 is also closer to the monocrystalline silicon rod 20, and the heat conduction path of the monocrystalline silicon rod 20 is also shorter. This is not limited in the embodiments of this application.

Optionally, a heat transfer structure dissipation structure is provided in a side wall of the secondary furnace chamber 102.

Specifically, in an implementation, in addition to performing contact-type heat transfer in the furnace using the above heat transfer assembly 11, a water-cooling flow path is further formed in a side wall of the secondary furnace chamber 102, the side wall of the secondary furnace chamber 102 is further connected with a water inlet and a water outlet, and both of the water inlet and the water outlet are in communication with the water-cooling flow path. Cold water may flow into the water-cooling flow path from the water inlet through a pumping device. After exchanging heat with the furnace, the cold water becomes hot water, which flows out from the water outlet. Therefore, when the water-cooling heat dissipation structure is used in combination with the heat transfer assembly 11, the heat transfer and heat dissipation effects can be greatly improved, the required temperature gradient can be quickly formed, and the crystal pulling speed can be increased.

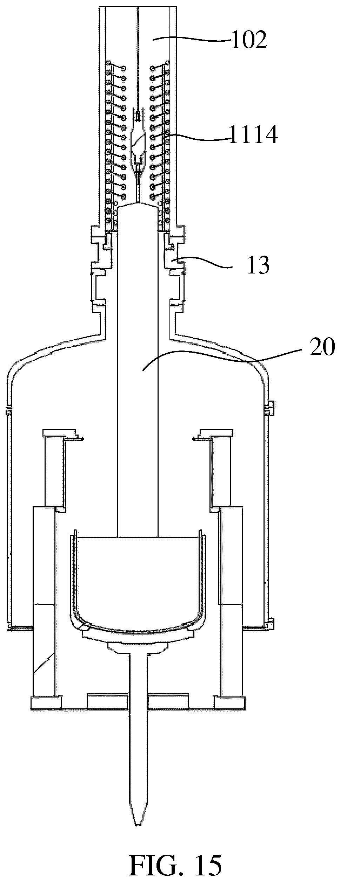

Referring to FIG. 15 to FIG. 17, the single crystal furnace provided by the embodiment of this application includes a furnace body and the heat conduction tool 112 of any one of the above embodiments. The heat conduction tool 112 includes a telescopic member 1121 and a heat conduction member 1122. The furnace body includes a furnace chamber, the furnace chamber is configured for growing the monocrystalline silicon rod 20, and the heat conduction member 1122 is configured to abut against a surface of the monocrystalline silicon rod 20. The heat transfer member 111 is arranged in the furnace chamber along an axial direction of the furnace body, and the axial direction of the furnace body is parallel to a length direction of the heat transfer member 111.

Specifically, the single crystal furnace is a crystal pulling equipment used for manufacturing the monocrystalline silicon rod 20. The single crystal furnace includes a furnace chamber, a raw silicon material is arranged at a bottom of the furnace chamber, and a cylindrical monocrystalline silicon rod 20 is gradually formed under the action of a lifting assembly. In the process of lifting and growing the monocrystalline silicon rod 20, the heat conduction member 1122 abuts against a surface of the monocrystalline silicon rod 20, and can conduct heat on the surface of the silicon rod to the furnace wall, thereby realizing heat dissipation and cooling of the silicon rod, and increasing the growth rate of the silicon rod. The heat transfer member 111 is arranged in the furnace chamber along the axial direction of the furnace body. The axial direction of the furnace body is parallel to a growth direction of the monocrystalline silicon rod 20 and also parallel to the length direction of the heat transfer member 111. A plurality of heat conduction assemblies are arranged along the length direction of the heat transfer member 111. Therefore, during the growth of the silicon rod, the surface of the silicon rod continuously abuts against the surfaces of heat conduction members 1122 in more heat conduction assemblies, so that the heat conduction effect is continuously improved as the monocrystalline silicon rod 20 grows, thereby ensuring an efficient heat conduction effect.

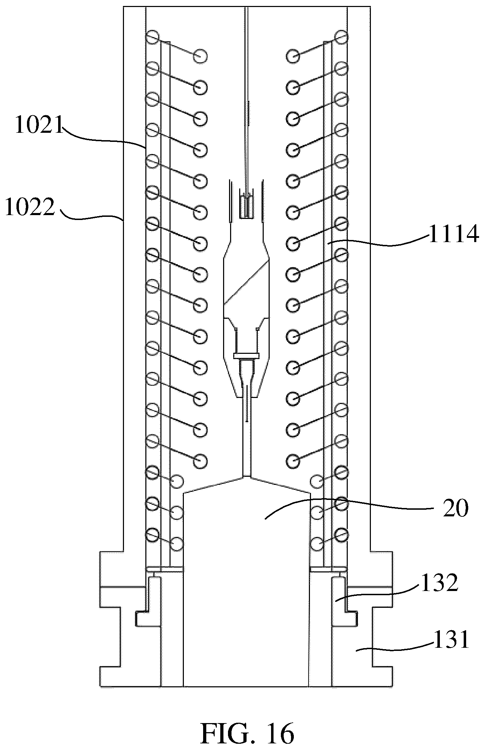

Optionally, referring to FIG. 15 and FIG. 16, the furnace chamber includes a secondary furnace chamber 102, and the heat transfer member 111 includes a first heat conduction portion 1114. Each of the heat conduction assemblies connected to the first heat conduction portion 1114 includes two heat conduction members 1122, and the two heat conduction members 1122 are connected to two ends of the telescopic member 1121. One of the heat conduction members 1122 is configured to abut against the surface of the monocrystalline silicon rod 20, and the other heat conduction member 1122 is configured to abut against the side wall of the secondary furnace chamber 102.

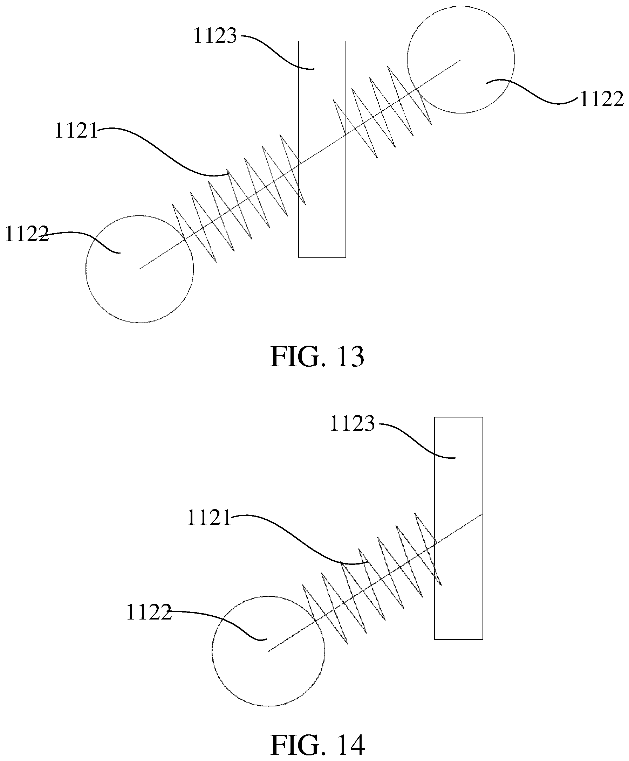

Specifically, as shown in FIG. 15, the furnace chamber includes a secondary furnace chamber 102. A dimension of the secondary furnace chamber 102 along the radial direction of the furnace body is small. The radial direction of the furnace body is a direction perpendicular to the axial direction of the furnace body. The secondary furnace chamber 102 is configured for secondary lifting and growth of the cylindrical monocrystalline silicon rod 20 that has been preliminarily formed. The heat transfer member 111 includes a first heat conduction portion 1114. Each heat conduction assembly connected to the first heat conduction portion 1114 includes two heat conduction members 1122. The two heat conduction members 1122 are fixedly connected to two opposite ends of the telescopic member 1121. The specific structure of the heat conduction assembly is shown in FIG. 13. The heat conduction member 1122 close to the side wall of the secondary furnace chamber 102 abuts against the side wall of the secondary furnace chamber 102, and the heat conduction member 1122 close to the monocrystalline silicon rod 20 abuts against the surface of the monocrystalline silicon rod 20, so that heat on the surface of the monocrystalline silicon rod 20 can be conducted to the side wall of the secondary furnace chamber 102. The heat conduction path of the heat conduction assembly in the secondary furnace chamber 102 is as follows: the heat of the monocrystalline silicon rod 20 is conducted to the heat conduction member 1122 close to the silicon rod in the heat conduction assembly, the heat conduction member 1122 conducts the heat to the telescopic member 1121, the telescopic member 1121 conducts the heat to the heat conduction member 1122 close to the side wall of the secondary furnace chamber 102 in the heat conduction assembly, and the heat conduction member 1122 conducts the heat to the side wall of the secondary furnace chamber 102. Therefore, in the single crystal furnace of this embodiment, heat on the surface of the monocrystalline silicon rod 20 can be conducted to the side wall of the secondary furnace chamber 102 through the plurality of heat conduction assemblies on the first heat conduction portion 1114 of the heat transfer member 111, thereby realizing heat dissipation and cooling of the monocrystalline silicon rod 20.

In an implementation, the heat conduction assembly connected to the first heat conduction portion 1114 may include only one heat conduction member 1122, the heat conduction member 1122 abuts against the surface of the monocrystalline silicon rod 20, and an end of the telescopic member 1121 distant from the heat conduction member 1122 directly abuts against the side wall of the secondary furnace chamber 102. This method can reduce the overall production cost of the single crystal furnace and simplify the structure inside the furnace. However, the telescopic member 1121 is likely to be in sufficient contact with the side wall of the secondary furnace chamber 102, which affects the heat conduction effect of the first heat conduction portion 1114. In this embodiment, the configuration of the heat conduction assembly including two heat conduction members 1122 can effectively ensure the heat conduction effect of the first heat conduction portion 1114, and provide more efficient heat dissipation and cooling for the monocrystalline silicon rod 20, thereby further facilitating the lifting and growth of the silicon rod.

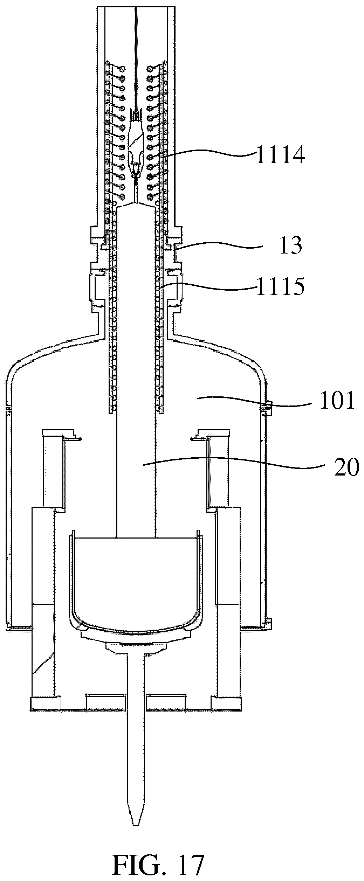

Optionally, referring to FIG. 17, the furnace chamber further includes a primary furnace chamber 101, the heat transfer member 111 further includes a second heat conduction portion 1115, and the second heat conduction portion 1115 and the first heat conduction portion 1114 are integrally formed. The heat conduction assembly connected to the second heat conduction portion 1115 includes one heat conduction member 1122, and the heat conduction member 1122 is configured to abut against the surface of the monocrystalline silicon rod 20.

Specifically, as shown in FIG. 17, the furnace chamber includes a primary furnace chamber 101. A dimension of the primary furnace chamber 101 along the radial direction of the furnace body is large. A raw silicon material is arranged at a bottom of the primary furnace chamber 101. The primary furnace chamber 101 is configured for forming the monocrystalline silicon rod 20 and preliminarily growing the monocrystalline silicon rod 20. In the continuous growth process, the monocrystalline silicon rod 20 extends into the secondary chamber for secondary growth. Because the primary furnace chamber 101 has a large volume, the heat conduction tool will not come into contact with the side wall of the primary furnace chamber 101 during the growth of the monocrystalline silicon rod 20. Therefore, the heat conduction assembly connected to the second heat conduction portion 1115 of the heat transfer member 111 includes only one heat conduction member 1122, and has a specific structure shown in FIG. 14, so as to simplify the structure of the heat conduction tool and reduce the manufacturing cost of the single crystal furnace. The heat conduction member 1122 in the heat conduction assembly abuts against the surface of the monocrystalline silicon rod 20, the end of the telescopic member 1121 distant from the heat conduction member 1122 is connected to the second heat conduction portion 1115 of the heat transfer member 111, and the heat conduction member 1122 can conduct heat on the surface of the monocrystalline silicon rod 20 to the telescopic member 1121, and then to the second heat conduction portion 1115. It should be noted that the second heat conduction portion 1115 and the first heat conduction portion 1114 of the heat transfer member 111 are integrally formed, i.e., heat on the second heat conduction portion 1115 can be conducted to the first heat conduction portion 1114. The heat conduction path of the heat conduction assembly in the primary furnace chamber 101 is as follows: the heat of the monocrystalline silicon rod 20 is conducted to the heat conduction member 1122 of the heat conduction assembly, the heat conduction member 1122 conducts the heat to the telescopic member 1121, the telescopic member 1121 conducts the heat to the second heat conduction portion 1115 of the heat transfer member 111, the second heat conduction portion 1115 conducts the heat to the first heat conduction portion 1114, and the first heat conduction portion 1114 conducts the heat to the side wall of the secondary furnace chamber 102 through the heat conduction assembly connected to the first heat conduction portion 1114. Therefore, in the single crystal furnace of this embodiment, heat on the surface of the monocrystalline silicon rod 20 can be finally conducted to the side wall of the secondary furnace chamber 102 through the joint action of the plurality of heat conduction assemblies on the second heat conduction portion 1115 and the first heat conduction portion 1114 of the heat transfer member 111, thereby realizing heat dissipation and cooling of the monocrystalline silicon rod 20.

Optionally, referring to FIG. 16, the side wall of the secondary furnace chamber 102 is a double-layer wall structure, including an inner wall 1021 and an outer wall 1022, a cooling medium is filled between the inner wall 1021 and the outer wall 1022, and the inner wall 1021 abuts against the heat conduction member 1122.

Specifically, as shown in FIG. 16, the side wall of the secondary furnace chamber 102 is a double-layer wall structure including an inner wall 1021 and an outer wall 1022, and a cooling medium is filled between the inner wall 1021 and the outer wall 1022. The cooling medium may be pure water, a mixed solution containing an organic alcohol, or an inert cooling gas, or the like. The specific composition of the cooling medium is not limited in this embodiment. The inner wall 1021 of the secondary furnace chamber 102 abuts against the heat conduction member 1122, and can absorb heat transferred from the heat conduction member 1122. After the heat is absorbed by the cooling medium between the inner wall 1021 and the outer wall 1022, the temperature is significantly lowered. Then, the remaining heat is continuously diffused to the outside environment through the outer wall 1022. As such, heat inside the single crystal furnace is conducted to the outside environment, thereby realizing the heat dissipation and cooling of the monocrystalline silicon rod 20 in the single crystal furnace. In a preferred implementation, a cooling device may be connected between the inner wall 1021 and the outer wall 1022 of the secondary furnace chamber 102, and the cooling device provides continuous heat dissipation and cooling for the cooling medium, to ensure that the cooling medium is continuously kept in a lower temperature range, so as to better absorb the heat transferred from the heat conduction member 1122, and further improve the heat dissipation and cooling effect.

Optionally, the heat transfer member 111 is of a cylindrical structure, the cylindrical structure surrounds a circumferential side of the monocrystalline silicon rod 20, and the heat conduction member 1122 is at least distributed on an inner side of the cylindrical structure.

Specifically, to enhance the heat conduction effect of the heat conduction tool, the heat transfer member 111 in the heat conduction tool may be designed as a cylindrical structure, and the heat transfer member 111 of the cylindrical structure may be connected to more heat conduction assemblies, thereby realizing more efficient heat conduction for the monocrystalline silicon rod 20. The heat transfer member 111 of the cylindrical structure surrounds the circumferential side of the monocrystalline silicon rod 20, and the diameter of the heat transfer member 111 is slightly larger than the diameter of the monocrystalline silicon rod 20. The heat conduction member 1122 in the heat conduction assembly is distributed on the side of the heat transfer member 111 close to the monocrystalline silicon rod 20, and can abut against the surface of the silicon rod during the growth of the monocrystalline silicon rod 20 to conduct heat on the surface of the silicon rod to the furnace wall, thereby realizing the heat dissipation and cooling of the silicon rod.

An embodiment of this application also provides a heat conduction tool 112. Referring to FIG. 13 and FIG. 14, the heat conduction tool 112 includes a heat transfer member 111 and a plurality of heat conduction assemblies. The plurality of heat conduction assemblies are arranged along a length direction of the heat transfer member 111 and are connected to the heat transfer member 111. Each of the heat conduction assemblies includes a telescopic member 1121 and a heat conduction member 1122, the telescopic member 1121 is connected to the heat transfer member 111, and the heat conduction member 1122 is fixedly connected to an end of the telescopic member 1121.

Specifically, a support portion 1123 in FIG. 13 and FIG. 14 is used in a single crystal furnace as the heat transfer member 111, and the heat transfer member 111 is a rigid rod member, which is not easily bent and deformed. The shape, structure, and dimensional specifications of the heat transfer member 111 may be set differently depending on different application scenarios of the heat conduction tool. When the heat conduction tool is used in a single crystal furnace equipment, the heat transfer member 111 may be configured as an elongated structure, such as an elongated column, an elongated rectangle, etc. The plurality of heat conduction assemblies are arranged along the length direction of the heat transfer member 111 and are connected to the heat transfer member 111. There is a gap between two adjacent heat conduction assemblies to ensure the heat conduction effect of the heat conduction assemblies. The size of the gap may be determined according to the number of heat conduction assemblies and the length ratio of the heat transfer member 111, so that the plurality of heat conduction assemblies are arranged as uniformly as possible along the length direction of the heat transfer member 111, to achieve uniform heat conduction of the heat conduction tool. It should be noted that the main function of the heat transfer member 111 is to support and fix the heat conduction assembly, and on this basis, the heat transfer member 111 also has a certain thermal conductivity, and can conduct heat of the plurality of heat conduction assemblies, so as to prevent the local temperature of the heat conduction tool from being too high to affect the heat conduction function.

Each of the heat conduction assemblies includes a telescopic member 1121 and a heat conduction member 1122. The telescopic member 1121 is connected to the heat transfer member 111. The telescopic member 1121 may be a telescopic rod structure in a nested form or elastically connected form, or may be an integrated elastically telescopic structure. The specific type is not limited in this embodiment. Depending on different types of the telescopic members 1121, the telescopic member 1121 may be fixedly connected to the heat transfer member 111 or may be elastically connected to the heat transfer member 111. The telescopic member 1121 can move relative to the heat transfer member 111 regardless of the connection mode. The heat conduction member 1122 is fixedly connected to an end of the telescopic member 1121. It should be noted that both the heat conduction member 1122 and the telescopic member 1121 have a good heat conduction effect and can realize heat conduction. In an implementation, as shown in FIG. 14, each of the heat conduction assemblies may include a heat conduction member 1122, and the heat conduction member 1122 is fixedly connected to an end of the telescopic member 1121. This type of heat conduction assembly has a simpler structure and lower processing cost, and helps reduce the production cost of the heat conduction tool. In another implementation, as shown in FIG. 13, each of the heat conduction assemblies may include two heat conduction members 1122, and the two heat conduction members 1122 are fixedly connected to two opposite ends of the telescopic member 1121. This type of heat conduction assembly has a relatively complex structure, but has a better heat conduction effect, and helps realize the rapid cooling of a component to be cooled. The type of the heat conduction assembly can be reasonably determined by those skilled in the art according to the heat conduction requirement, processing cost, and the like, and is not limited in this embodiment.

During the heat conduction process of the heat conduction tool, the heat conduction member 1122 needs to be in contact with the surface of the component to be cooled. After coming into contact with the surface of the component to be cooled, the heat conduction member 1122 can conduct heat of the component to be cooled to the heat conduction member 1122, which conducts the heat to the telescopic member 1121 connected to the heat conduction member 1122. If the heat conduction assembly includes one heat conduction member 1122, the telescopic member 1121 directly conducts the heat to an external cooling and heat dissipation component. If the heat conduction assembly includes two heat conduction members 1122, the telescopic member 1121 conducts the heat to the other heat conduction member 1122, and the other heat conduction member 1122 conducts the heat to the external cooling and heat dissipation component. For example, if the heat conduction tool is arranged in a single crystal furnace to conduct heat of a monocrystalline silicon rod grown by crystal pulling, one heat conduction member 1122 in the heat conduction assembly needs to abut against the surface of the monocrystalline silicon rod, to conduct heat on the surface of the monocrystalline silicon rod to the telescopic member 1121 connected to the heat conduction member 1122. If the heat conduction assembly includes one heat conduction member 1122, the telescopic member 1121 directly abuts against a furnace wall of the single crystal furnace, so that heat is conducted to the furnace wall of the single crystal furnace, and then diffused to the outside environment through the furnace wall, thereby realizing cooling and heat dissipation of the monocrystalline silicon rod. If the heat conduction assembly includes two heat conduction members 1122, the telescopic member 1121 conducts heat to the heat conduction member 1122 at the other end thereof, and the heat conduction member 1122 abuts on the furnace wall of the single crystal furnace, conducts heat to the furnace wall of the single crystal furnace, and then diffuses from the furnace wall to the external environment, thereby realizing cooling and heat dissipation of the monocrystalline silicon rod.

It should be noted that the heat conduction member 1122 and the telescopic member 1121 may be made of different thermally conductive materials. The heat conduction member 1122 needs to abut against the surface of the component to be cooled, and therefore is made of a material with good thermal conductivity and good wear resistance. The telescopic member 1121 not only need to conduct heat, but also needs to provide a good supporting and stabilizing effect for the heat conduction member 1122, and therefore is made of a material with good thermal conductivity and good strength and rigidity. In a preferred implementation, the heat conduction member 1122 may be made of a silver alloy, which has good thermal conductivity and ductility, more stable chemical properties, and good high temperature resistance, corrosion resistance, and friction resistance, and can ensure long-term and efficient use of the heat conduction member 1122 in the single crystal furnace environment. The telescopic member 1121 may be made of a carbon alloy, such as iron-carbon alloy, carbon steel, etc. The carbon alloy has certain thermal conductivity, good strength and rigidity, and low processing cost, and can effectively reduce the processing cost of the heat conduction tool while providing the heat conduction and supporting functions. Of course, the specific materials of the heat conduction member 1122 and the telescopic member 1121 are not limited in this embodiment.

The heat conduction tool 112 of this application may be arranged in a single crystal furnace to conduct heat of a monocrystalline silicon rod. The heat conduction tool includes a heat transfer member 111 and a plurality of heat conduction assemblies. Each of the heat conduction assemblies includes a telescopic member 1121 and a heat conduction member 1122. The telescopic member 1121 is connected to the heat transfer member 111. The heat conduction member 1122 is fixedly connected to an end of the telescopic member 1121. During the growth of the monocrystalline silicon rod, the heat conduction member 1122 may abut against the surface of the monocrystalline silicon rod. After coming into contact with the surface of the monocrystalline silicon rod, the heat conduction member 1122 can conduct heat on the surface of the monocrystalline silicon rod to the telescopic member 1121, and then the heat is conducted to a furnace wall of the single crystal furnace through the telescopic member 1121, and diffused to the outside environment through the furnace wall, thereby realizing the heat dissipation and cooling of the monocrystalline silicon rod. Since an uneven surface of the monocrystalline silicon rod is formed during growth in the single crystal furnace, the heat conduction member 1122 may not be in sufficient contact with the surface of the monocrystalline silicon rod. The telescopic member 1121 in the heat conduction tool of this application can drive the heat conduction member 1122 to undergo telescopic movement, and the heat conduction member 1122 can be in sufficient contact with the uneven surface of the monocrystalline silicon rod through continuous telescopic movement, thereby ensuring a good heat conduction effect and avoiding the phenomenon of slow growth speed caused by excessively high temperature of the monocrystalline silicon rod. In addition, since the telescopic member 1121 drives the heat conduction member 1122 to undergo telescopic movement, the pressure generated by the heat conduction member 1122 on the surface of the monocrystalline silicon rod can also be alleviated, to prevent the heat conduction member 1122 from damaging the surface of the monocrystalline silicon rod during contact with the monocrystalline silicon rod, thereby effectively improving the growth quality of the monocrystalline silicon rod.

Optionally, referring to FIG. 13 and FIG. 14, the heat conduction member 1122 is of a spherical structure.

Specifically, during the growth of the monocrystalline silicon rod in the single crystal furnace by crystal pulling, due to uneven tensile stress, the surface of the silicon rod is usually formed with uneven structures, such as pits, etc. Therefore, the configuration of the heat conduction member 1122 as a spherical structure can increase the contact area between the heat conduction member 1122 and the surface of the silicon rod, thereby improving the heat conduction effect of the heat conduction member 1122 and accelerating the heat dissipation and cooling of the monocrystalline silicon rod.

Optionally, referring to FIG. 13 and FIG. 14, the telescopic member 1121 is a spring or a telescopic rod.

Specifically, the telescopic member 1121 is a spring or a telescopic rod. FIG. 13 and FIG. 14 show that the telescopic member 1121 is in the form of a compression spring. The compression spring is compressed to a small extent by the part of the surface of the silicon rod formed with pits, and is compressed to a large extent by the part of the surface of the silicon rod formed with bumps. The heat conduction member 1122 is fixed to an end of the spring, and undergoes telescopic movement along with the deformation of the spring, so as to achieve a sufficient contact with the surface of the silicon rod. Alternatively, the telescopic member 1121 is a telescopic rod. The telescopic rod includes two rods, where one rod is provided inside the other rod and can move relative to the other rod. The telescopic rod relatively extends out by a length at the part of the surface of the silicon rod formed with pits, and retracts by a length at the part of the surface of the silicon rod formed with bumps. The heat conduction member 1122 is fixed to an end of the telescopic rod, and undergoes telescopic movement along with the telescopic rod, so as to achieve a sufficient contact with the surface of the silicon rod.

Optionally, referring to FIG. 13 and FIG. 14, an arrangement direction of the telescopic member 1121 is inclined relative to the length direction of the heat transfer member 111.

Specifically, the arrangement direction of the telescopic member 1121 is inclined relative to the length direction of the heat transfer member 111. The telescopic member 1121 may be inclined upward or downward toward the growth direction of the monocrystalline silicon rod. When the telescopic member 1121 is in the inclined state, the contact stress between the heat conduction member 1122 at the end of the telescopic member 1121 and the surface of the silicon rod is small, so that the surface of the silicon rod is less likely to be damaged, thereby facilitating the lifting and growth of the silicon rod.

An embodiment of this application also provides a crystal pulling temperature control method for the single crystal furnace. A heat transfer assembly 11 rotatable relative to the furnace body 10 of the single crystal furnace is arranged in the furnace body. The method includes:
conducting heat of the monocrystalline silicon rod 20 through the heat transfer assembly 11 when the monocrystalline silicon rod 20 is in contact with the heat transfer assembly 11, where, a rotational speed of the heat transfer assembly 11 is the same as a rotational speed of the monocrystalline silicon rod 20.

Specifically, in an implementation, in the single crystal furnace of the above embodiment, the heat transfer assembly 11 can rotate relative to the furnace body 10. In the crystal pulling process, the rotational speed of the monocrystalline silicon rod 20 may be obtained by monitoring a rotational speed of the lifting assembly 12 in real time, and a controller of the single crystal furnace sends a motor driving signal to a drive control board of the rotary assembly 13, so that when the motor drives the heat transfer assembly 11 to rotate, the rotational speed of the heat transfer assembly 11 is the same as the rotational speed of the monocrystalline silicon rod 20. In this way, when the monocrystalline silicon rod 20 comes into contact with the heat transfer assembly 11, the monocrystalline silicon rod 20 and the heat transfer assembly 11 can rotate synchronously, and there is no relative rotation error, so the rotational speed of the monocrystalline silicon rod 20 will not be reduced by the heat transfer assembly 11, thereby effectively ensuring the crystal pulling quality. Therefore, according to the crystal pulling temperature control method, not only a good temperature gradient can be formed through the heat transfer assembly 11, but also wire breakage defects in crystal pulling can be eliminated.

As used herein, the terms such as "an embodiment," "the embodiment," and "one or more embodiments" mean that specific features, structures, or characteristics described with reference to the embodiment are embraced in at least one embodiment of this application. It should also be noted that the terms such as "in an embodiment" herein do not necessarily all refer to the same embodiment.

In the specification provided herein, numerous specific details have been described. However, it can be understood that embodiments of this application can be practiced without these specific details. In some examples, well-known methods, structures, and techniques are not described in detail herein, so as not to obscure the understanding of the present specification.

In the claims, reference signs in parentheses should not be construed as limiting the claims. The terms such as "include", "comprise", and their variants do not exclude the presence of elements or steps not listed in the claims. The terms such as "a", "an", or "one" preceding an element do not exclude the presence of a plurality of such elements. This application may be implemented by means of hardware including several different elements and by means of a suitably programmed computer. In a unit claim where several devices are mentioned, some of these devices may be embodied by the same hardware claim. As used herein, the terms such as first, second, third, etc. do not indicate any order. These terms can be interpreted as names.

Finally, it should be noted that the above embodiments are intended to illustrate, instead of limiting the technical solutions of this application. Although this application is described in detail by way of examples, it should be understood by those of ordinary skill in the art that modifications may be made to the technical solutions described in the embodiments, and equivalents may be substituted for some technical features, without essentially departing from the spirit and scope of the technical solutions described in the embodiments of this application.

## Claims

1. A single crystal furnace, comprising a furnace body and a heat transfer assembly, wherein the furnace body is configured to grow a monocrystalline silicon rod;
in an axial direction of the furnace body, the heat transfer assembly is arranged in the furnace body; and
the heat transfer assembly is configured to contact with the monocrystalline silicon rod and conduct heat of the monocrystalline silicon rod.

2. The single crystal furnace according to claim 1, wherein the heat transfer assembly comprises a heat transfer member, and the heat transfer member comprises a cylinder arranged in the furnace body; and
the cylinder is configured to contact with the monocrystalline silicon rod and conduct the heat of the monocrystalline silicon rod.

3. The single crystal furnace according to claim 2, wherein the heat transfer assembly further comprises a heat conduction tool, and the heat conduction tool is arranged on the heat transfer member and/or on an inner surface of the furnace body.

4. The single crystal furnace according to claim 3, wherein a material of the heat conduction tool comprises any one of a carbon-carbon material, a graphite material, and silicone grease.

5. The single crystal furnace according to claim 4, wherein an inner diameter of the cylinder is smaller than a diameter of the monocrystalline silicon rod;
the heat transfer member further comprises a flange arranged on an outer surface of the cylinder, the flange radially extends in a direction away from an axis of the cylinder, and the flange is configured to abut against and fit with the furnace body; and
a head of the monocrystalline silicon rod is in contact with an end portion of the cylinder to push the flange to separate from the furnace body.

6. The single crystal furnace according to claim 5, wherein the heat conduction tool is fixed to an outer surface of the heat transfer member, and/or the heat conduction tool is fixed to the inner surface of the furnace body.

7. The single crystal furnace according to claim 6, wherein the heat transfer member further comprises a pressing plate; and
the heat conduction tool is arranged on a surface of the flange facing away from the monocrystalline silicon rod along a circumferential direction of the flange, and the pressing plate is stacked on the flange to retain and fix the heat conduction tool.

8. The single crystal furnace according to claim 4, wherein an inner diameter of the cylinder is larger than a diameter of the monocrystalline silicon rod; and
the monocrystalline silicon rod passes through the cylinder, and the cylinder conducts the heat of the monocrystalline silicon rod to the furnace body.

9. The single crystal furnace according to claim 8, wherein the heat conduction tool is arranged on each of an inner surface and an outer surface of the cylinder; and
the heat conduction tool on the inner surface of the cylinder is configured to contact with the monocrystalline silicon rod, and the heat conduction tool on the outer surface of the cylinder is configured to contact with the furnace body.

10. The single crystal furnace according to any one of claims 2 to 9, wherein the single crystal furnace further comprises a rotary assembly; and
the rotary assembly is connected to the furnace body, and is configured to drive the heat transfer member to rotate relative to the furnace body.

11. The single crystal furnace according to claim 10, wherein the rotary assembly comprises an outer stator and an inner rotor;
the outer stator is fixedly connected to the furnace body, and the inner rotor is arranged in the outer stator and is rotatably connected to the outer stator; and
the inner rotor is configured to drive the heat transfer member to rotate relative to the furnace body.

12. The single crystal furnace according to claim 10, wherein the rotary assembly comprises a rotary ring and a slewing transmission mechanism;
the slewing transmission mechanism is fixedly connected to the furnace body, and is configured to drive the rotary ring to rotate relative to the furnace body; and
the rotary ring is configured to drive the heat transfer member to rotate relative to the furnace body.

13. The single crystal furnace according to claim 10, wherein the furnace body comprises a primary furnace chamber, a secondary furnace chamber, and an isolation valve;
the isolation valve is connected between the primary furnace chamber and the secondary furnace chamber; and
the rotary assembly is arranged between the isolation valve and the primary furnace chamber, or the rotary assembly is arranged between the isolation valve and the secondary furnace chamber.

14. The single crystal furnace according to claim 13, wherein a heat transfer structure dissipation structure is provided in a side wall of the secondary furnace chamber.

15. The single crystal furnace according to claim 13, wherein the heat conduction tool comprises a plurality of heat conduction assemblies;
the plurality of heat conduction assemblies are arranged along a length direction of the heat transfer member and are connected to the heat transfer member; and
each of the heat conduction assemblies comprises a telescopic member and a heat conduction member, the telescopic member is connected to the heat transfer member, and the heat conduction member is fixedly connected to an end of the telescopic member.

16. The single crystal furnace according to claim 15, wherein the furnace body comprises a furnace chamber, the furnace chamber is configured for growing the monocrystalline silicon rod, and the heat conduction member is configured to abut against a surface of the monocrystalline silicon rod; and
the heat transfer member is arranged in the furnace chamber along an axial direction of the furnace body, and the axial direction of the furnace body is parallel to a length direction of the heat transfer member.

17. The single crystal furnace according to claim 16, wherein the furnace chamber comprises a secondary furnace chamber, and the heat transfer member comprises a first heat conduction portion;
each of the heat conduction assemblies connected to the first heat conduction portion comprises two heat conduction members, and the two heat conduction members are connected to two ends of the telescopic member; and
one of the heat conduction members is configured to abut against the surface of the monocrystalline silicon rod, and the other heat conduction member is configured to abut against the side wall of the secondary furnace chamber.

18. The single crystal furnace according to claim 17, wherein the furnace chamber further comprises a primary furnace chamber, the heat transfer member further comprises a second heat conduction portion, and the second heat conduction portion and the first heat conduction portion are integrally formed; and
the heat conduction assembly connected to the second heat conduction portion comprises one heat conduction member, and the heat conduction member is configured to abut against the surface of the monocrystalline silicon rod.

19. The single crystal furnace according to claim 17, wherein the side wall of the secondary furnace chamber is a double-layer wall structure, comprising an inner wall and an outer wall; and
a cooling medium is filled between the inner wall and the outer wall, and the inner wall abuts against the heat conduction member.

20. The single crystal furnace according to claim 16, wherein the heat transfer member is of a cylindrical structure, the cylindrical structure surrounds a circumferential side of the monocrystalline silicon rod, and the heat conduction member is at least distributed on an inner side of the cylindrical structure.

21. A heat conduction tool, comprising a heat transfer member and a plurality of heat conduction assemblies, wherein
the plurality of heat conduction assemblies are arranged along a length direction of the heat transfer member and are connected to the heat transfer member; and
each of the heat conduction assemblies comprises a telescopic member and a heat conduction member, the telescopic member is connected to the heat transfer member, and the heat conduction member is fixedly connected to an end of the telescopic member.

22. The heat conduction tool according to claim 21, wherein the heat conduction member is of a spherical structure.

23. The heat conduction tool according to claim 21, wherein the telescopic member is a spring or a telescopic rod.

24. The heat conduction tool according to claim 23, wherein an arrangement direction of the telescopic member is inclined relative to the length direction of the heat transfer member.

25. A crystal pulling temperature control method for a single crystal furnace, wherein a heat transfer assembly rotatable relative to a furnace body of the single crystal furnace is arranged in the furnace body, the method comprising:
conducting heat of the monocrystalline silicon rod through the heat transfer assembly when the monocrystalline silicon rod is in contact with the heat transfer assembly, wherein, a rotational speed of the heat transfer assembly is the same as a rotational speed of the monocrystalline silicon rod.
